# EUROPÄISCHE PATENTANMELDUNG

(11) **EP 0 848 513 A2**
(43) Veröffentlichungstag der Anmeldung: **17.06.1998**
(21) Anmeldenummer: 97115304.4
(22) Anmeldetag: 04.09.1997
(51) Int. Cl.: H04J 3/06

(54) **Anordnung zum Gewinnen eines gemeinsamen Verarbeitungstaktes für mehrere Daten-signale**

(30) Priorität: 13.12.1996 DE 19651834
(71) Anmelder: ROBERT BOSCH GMBH, 70442 Stuttgart (DE)
(72) Erfinder: Ruthemann, Klaus, 71522 Backnang (DE)

(57) **Zusammenfassung**

Eine mit geringem Schaltungsaufwand realisierbare Anordnung zum Herleiten eines gemeinsamen Verarbeitungstaktes für mehrere Datensignale, deren Takte frequenzgleich, aber gegeneinander phasenverschoben sind, besitzt für jedes Datensignal (D1) einen Phasendiskriminator (PD1), der die Phasenablage seines individuellen Taktes (TS1) gegenüber dem gemeinsamen Verarbeitungstakt (TL) in Form eines pulsbreitenmodulierten Signals (P1) wiedergibt. Außerdem ist ein Multiplexer (MUX) vorgesehen, der alle eingangsseitig parallel anliegenden pulsbreitenmodulierten Phasenablagesignale (P1, ..., Pn) zyklisch nacheinander auf einen seriellen Ausgang durchschaltet. Aus dem seriellen pulsbreitenmodulierten Ausgangssignal (PS) des Multiplexers (MUX) wird ein Regelkriterium (PSM) für den Verarbeitungstakt (TL) abgeleitet.

## Beschreibung

### Stand der Technik

Die vorliegende Erfindung betrifft eine Anordnung zum Gewinnen eines gemeinsames Verarbeitungstaktes für mehrere parallele Datensignale, deren individuelle Takte frequenzgleich, aber gegeneinander phasenverschoben sind.

Im Bereich digitaler Signalverarbeitung tritt häufiger das Problem auf, daß mehrere parallel empfangene Datensignale, deren Takte frequenzgleich, aber gegeneinander phasenverschoben sind, mit einem gemeinsamen Takt gleicher Frequenz weiterverarbeitet werden sollen. Z.B. in Richtfunksystemen ist die gemeinsame Verarbeitung mehrerer empfangener Datenkanäle zu lösen.

Der Erfindung liegt nun die Aufgabe zugrunde, eine Anordnung der eingangs genannten Art anzugeben, die mit möglichst geringem Schaltungsaufwand aus den frequenzgleichen, aber gegeneinander phasenverschobenen Takten mehrerer paralleler Datensignale einen gemeinsamen Verarbeitungstakt herleitet.

### Vorteile der Erfindung

Zur Lösung dieser Aufgabe ist gemäß den Merkmalen des Patentanspruchs 1 für jedes Datensignal ein Phasendiskriminator vorhanden, der die Phasenablage des individuellen Taktes eines jeden Datensignals gegenüber dem gemeinsamen Verarbeitungstakt in Form eines pulsbreitenmodulierten Signals wiedergibt. Ein Multiplexer schaltet alle eingangsseitig parallel anliegenden pulsbreitenmodulierten Phasenablagesignale zyklisch nacheinander, jeweils für die Dauer einer Periode der pulsbreitenmodulierten Phasenablagesignale, auf einen seriellen Ausgang durch. Schließlich sind Mittel vorhanden, welche aus dem seriellen pulsbreitenmodulierten Ausgangssignal des Multiplexers ein Regelkriterium für den Verarbeitungstakt ableiten.

Zweckmäßige Aus- und Weiterbildungen der Erfindung nach Anspruch 1 gehen aus den Unteransprüchen hervor. So kann z. B. als Regelkriterium für den gemeinsamen Verarbeitungstakt der arithmetische Mittelwert des pulsbreitenmodulierten Ausgangssignals des Multiplexers verwendet werden, wobei ein Tiefpaß den arithmetischen Mittelwert bilden kann. Vorteilhafterweise ist der Multiplexer so steuerbar, daß bei der zyklischen Durchschaltung der eingangsseitig parallel anliegen pulsbreitenmodulierten Phasenablagesignale auf den seriellen Ausgang beliebige Eingangssignale ausgespart werden können, ohne daß dadurch im seriellen pulsbreitenmodulierten Ausgangssignal Lücken entstehen. Datensignale mit zu geringen Empfangspegeln sollten bei der Ableitung des gemeinsamen Verarbeitungstaktes ausgespart werden. Da der Multiplexer diese Signale lückenlos überspringen kann, bleibt die wirksame Steilheit des Regelkriteriums unabhängig von der Anzahl der beteiligten Taktsignale.

Die Phasendiskriminatoren können in einer sehr einfachen Ausführung RS-Flipflops sein.

Für jedes der parallelen Datensignale sei beispielsweise ein elastischer Speicher vorgesehen. Dann ermittelt der zu einem jeden Datensignal gehörende Phasendiskriminator die Phasenablage zwischen dem zyklisch auftretenden Überlaufimpuls eines Schreibtakt-Zählers, welcher starr vom individuellen Datensignaltakt abhängt, und dem zyklisch auftretenden Überlaufimpuls eines Lesetakt-Zählers, welcher starr vom gemeinsamen Verarbeitungstakt abhängt. Mit dem gewonnenen Regelkriterium wird der Lesetakt des elastischen Speichers jedes Datensignals geregelt. Ein mit dem Regelkriterium beaufschlagter spannungsgesteuerter Oszillator kann den Lesetakt erzeugen.

### Beschreibung eines Ausführungsbeispiels

Anhand eines in der Zeichnung dargestellten Ausführungsbeispiels wird nachfolgend die Erfindung erläutert. Es zeigen:
- Figur 1: ein Blockschaltbild für die Herleitung eines gemeinsamen Verarbeitungstaktes und
- Figur 2: ein Impulsdiagramm mehrerer Phasenablagesignale.

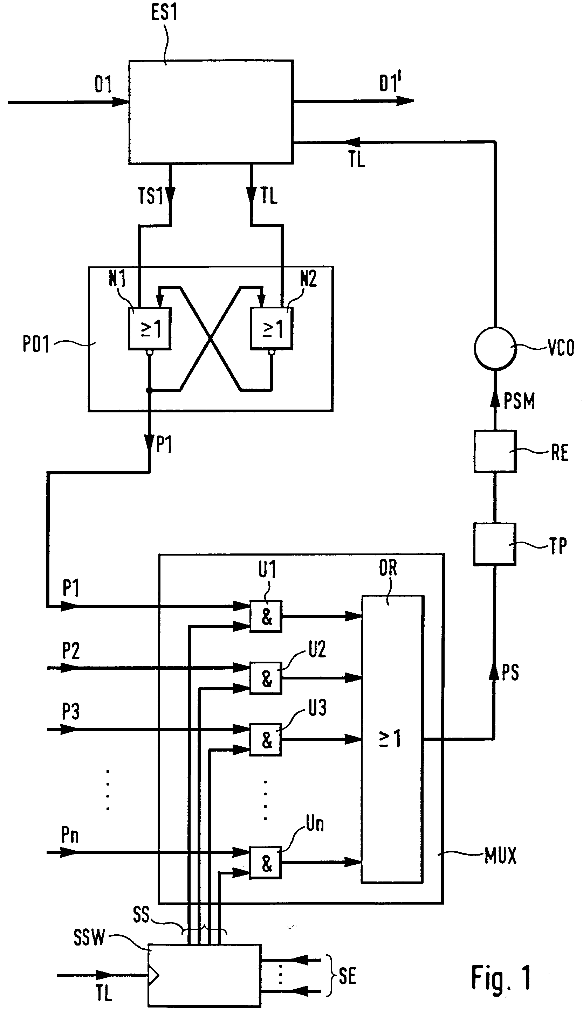

Der in Figur 1 dargestellten Schaltung werden n Datensignale zugeführt, von denen beispielhaft nur das erste Datensignal D1 eingezeichnet ist. Alle Datensignale haben dieselbe Taktfrequenz, die Taktsignale sind aber unter Umständen nicht phasengleich. Wie einleitend ausgeführt, soll für die weitere Verarbeitung aller Datensignale ein gemeinsamer Verarbeitungstakt aus den individuellen Takten der eingehenden Datensignale gewonnen werden.

Die nachfolgend beschriebene Taktverarbeitung für das Datensignal D1 wird in gleicher Weise für jedes der parallel eingehenden Datensignale D1 ... Dn durchgeführt. Das Datensignal D1 wird einem elastischen Speicher ES1 zugeführt. Der Schreibtakt TS1 des elastischen Speichers ES1 entspricht dem individuellen Takt des eingehenden Datensignals D1. Am Ausgang des elastischen Speichers ES1 erscheint das Datensignal D1' mit dem Lesetakt TL. Dieser Lesetakt TL soll für alle elastischen Speicher sämtlicher Datensignale frequenz- und phasengleich sein. Dazu müssen entweder die Lesetaktzähler, d.h. die Adresszähler der Leseseiten, aller elastischen Speicher aufeinander synchronisiert sein, oder es gibt überhaupt nur einen Lesetaktzähler, der die Leseadressen aller elastischen Speicher zentral bestimmt.

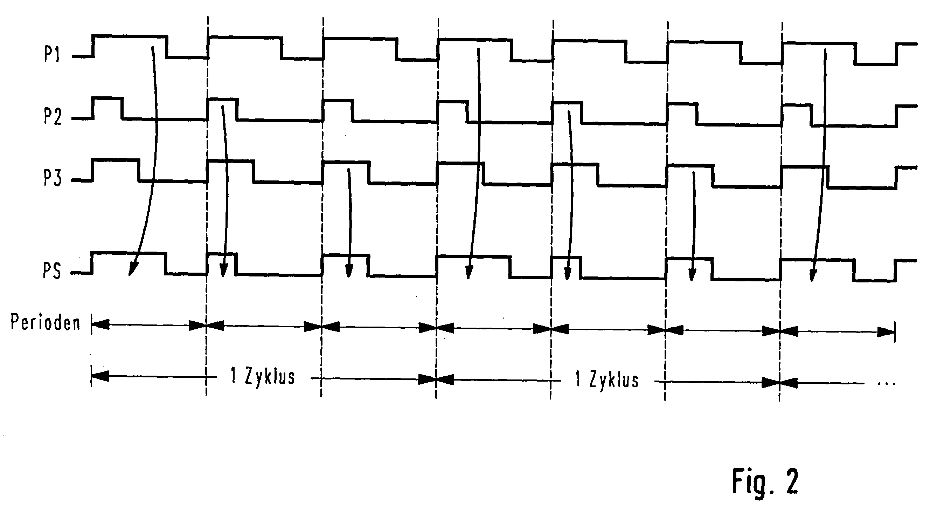

Mit der anschließend beschriebenen Regelschleife wird der Lesetakt TL aller elastischen Speicher auf einen gemeinsamen Verarbeitungstakt geregelt. Sowohl der Überlaufimpuls des Schreibtakt-Zählers - nachfolgend als Schreibtakt TS1 bezeichnet - als auch der Überlaufimpuls des Lesetakt-Zählers - nachfolgend als Lesetakt TL bezeichnet - werden einem Phasendiskriminator PD1 zugeführt. Dieser Phasendiskriminator PD1 erzeugt ein Signal P1 an seinem Ausgang, das der Phasenablage zwischen dem Schreibtakt TS1 und dem Lesetakt TL entspricht. Das Phasenablagesignal P1 hat somit in jeder Periode einen Impuls, dessen Breite der Phasenablage zwischen dem Schreibtakt TS und dem Lesetakt TL in der jeweiligen Periode entspricht. P1 ist also, wie in Figur 2 dargestellt, ein pulsbreitenmoduliertes Signal. In einer sehr einfachen Ausführung besteht der Phasendiskriminator PD1, wie Figur 1 zeigt, aus einem RS-Flipflop, das sich in bekannter Weise mit zwei NOR-Gattern N1 und N2 realisieren läßt. Auch andere Ausführungsformen für den Phasendiskriminator PD1 kommen in Frage.

Auf dieselbe Weise, wie zuvor beschrieben, wird für jedes der eingehenden Datensignale D1 ... Dn ein pulsbreitenmoduliertes Phasenablagesignal P1, P2, P3, ..., Pn gebildet. In der Figur 2 sind beispielsweise drei solche pulsbreitenmodulierte Phasenablagesignale P1, P2, P3 dargestellt. Da alle Phasendiskriminatoren denselben Lesetakt TL erhalten, sind die Perioden der pulsbreitenmodulierten Phasenablagesignale P1, P2, P3, ..., Pn phasengleich. Alle pulsbreitenmodulierten Phasenablagesignale P1, P2, P3, ..., Pn werden parallel einem Multiplexer MUX zugeführt. Der Multiplexer MUX schaltet die eingangsseitig parallel anliegenden pulsbreitenmodulierten Phasenablagesignale P1, P2, P3, ..., Pn zyklisch nacheinander, jeweils für die Dauer einer Periode, auf einen seriellen Ausgang durch. Das Ausgangssignal PS des Multiplexers MUX hat dann z. B. die in der Figur 2 angegebene Form. Wenn alle Eingangssignale P1, P2, P3, ..., Pn durchgeschaltet worden sind, beginnt ein neuer Durchschaltezyklus, wie in Figur 2 durch die Pfeile angedeutet ist.

Eine sehr einfache Ausführung eines solchen Multiplexers MUX ist in der Figur 1 dargestellt. Er besitzt für jedes Eingangssignal P1, P2, P3, ..., Pn ein UND-Gatter U1, U2, U3, ..., Un. Ein erster Eingang jedes UND-Gatters U1, U2, U3, ..., Un ist von dem zugehörigen Eingangssignal P1, P2, P3, ..., Pn und der zweite Eingang von einem Steuersignal SS eines Schrittschaltwerkes SSW belegt. Das Schrittschaltwerk SSW erhält den Lesetakt TL, mit dem das Schrittschaltwerk SSW in seinem Steuersignal SS eine logische 1 nacheinander an die einzelnen UND-Gatter U1, U2, U3, ..., Un legt. Weiterhin besitzt der Multiplexer MUX ein ODER-Gatter OR, an dessen Eingängen die Ausgänge der UND-Gatter U1, U2, U3, ..., Un anliegen. Wenn, wie zuvor beschrieben, die UND-Gatter U1, U2, U3, ..., Un die Eingangssignale P1, P2, P3, ..., Pn der Reihe nach auf das ODER-Gatter OR durchschalten, so entsteht an seinem Ausgang das pulsbreitenmodulierte Ausgangssignal PS.

Nicht geeignete Datensignale, z. B. solche mit zu geringem Empfangspegel, sollen nicht zu einem Regelkriterium für den gemeinsamen Verarbeitungstakt, den Lesetakt TL, beitragen. Solche Datensignale können durch das Schrittschaltwerk SSW ausgeschieden werden, indem sein Steuersignal SS die pulsbreitenmodulierten Phasenablagesignale der unerwünschten Datensignale im Zyklus übergeht und ohne Verzug das in Zyklusrichtung nächste zugelassene Datensignal durchschaltet. Ein Eingangssteuersignal SE teilt dem Schrittschaltwerk SSW mit, welche der Datensignale ungeeignet sind, d. h. welche der pulsbreitenmodulierten Phasenablagesignale P1, P2, P3, ..., Pn nicht auf den Ausgang des Multiplexers MUX durchgeschaltet werden sollen. Im pulsbreitenmodulierten Ausgangssignal des Multiplexers MUX entstehen durch die ausgesparten pulsbreitenmodulierten Phasenablagesignale P1, P2, P3, ..., Pn keine Lücken, welche die Kennliniensteilheit des aus dem Signal PS abgeleiteten Regelkriteriums beeinflussen könnten.

Von dem pulsbreitenmodulierten Ausgangssignal PS des Multiplexers MUX wird der arithmetische Mittelwert PSM gebildet, welcher als Regelkriterium und für einen spannungsgesteuerten Oszillator VCO verwendet wird. Der arithmetische Mittelwert PSM aus dem pulsbreitenmodulierten Ausgangssignals des Multiplexers MUX kann z. B. mit einem Tiefpaß TP abgeleitet werden. Das Ausgangssignal des mit dem Regelkriterium PSM beaufschlagten spannungsgesteuerten Oszillators VCO ist der für alle elastischen Speicher vorgesehene Lesetakt TL. Dem spannungsgesteuerten Oszillator VCO ist, wie in Phasenregelschleifen üblich, ein Regelverstärker (z. B. PI-Regler) vorgeschaltet.

## Patentansprüche

1. Anordnung zum Gewinnen eines gemeinsamen Verarbeitungstaktes für mehrere parallele Datensignale, deren individuelle Takte frequenzgleich, aber gegeneinander phasenverschoben sind, dadurch gekennzeichnet,
- daß für jedes Datensignal (D1) ein Phasendiskriminator (PD1)die Phasenablage seines individuellen Taktes (TS1) gegenüber dem gemeinsamen Verarbeitungstakt (TL) in Form eines pulsbreitenmodulierten Signals (P1) wiedergibt.
- daß ein Multiplexer (MUX) alle eingangsseitig parallel anliegenden pulsbreitenmodulierten Phasenablagesignale (P1, ..., Pn) zyklisch nacheinander, jeweils für die Dauer einer Periode der pulsbreitenmodulierten Phasenablagesignale, auf einen seriellen Ausgang durchschaltet.
- und daß Mittel (TP) vorhanden sind, welche aus dem seriellen pulsbreitenmodulierten Ausgangssignal (PS) des Multiplexers (MUX) ein Regelkriterium (PSM) für den Verarbeitungstakt (TL) ableiten.

2. Anordnung nach Anspruch 1, dadurch gekennzeichnet, daß Mittel (TP) vorgesehen sind, welche als Regelkriterium den arithmetischen Mittelwert (PSM) des pulsbreitenmodulierten Ausgangssignals (PS) des Multiplexers (MUX) bilden.

3. Anordnung nach Anspruch 2, dadurch gekennzeichnet, daß ein Tiefpaß (TP) den arithmetischen Mittelwert (PSM) des pulsbreitenmodulierten Ausgangssignals (PS) des Multiplexers (MUX) bildet.

4. Anordnung nach Anspruch 1, dadurch gekennzeichnet, daß der Multiplexer (MUX) so steuerbar ist, daß bei der zyklischen Durchschaltung der eingangsseitig parallel anliegenden pulsbreitenmodulierten Phasenablagesignale (P1, ..., Pn) auf den seriellen Ausgang beliebige Eingangssignale (P1,..., Pn) ausgespart werden können, ohne daß dadurch im seriellen pulsbreitenmodulierten Ausgangssignal (PS) Lücken entstehen.

5. Anordnung nach Anspruch 1, dadurch gekennzeichnet, daß die Phasendiskriminatoren (PD1) RS-Flipflops (N1, N2) sind.

6. Anordnung nach einem der vorhergehenden Ansprüche, dadurch gekennzeichnet,
- daß für jedes der parallelen Datensignale (D1) ein elastsicher Speicher (ES1) vorgesehen ist,
- daß der zu einem jeden Datensignal (D1) gehörender Phasendiskriminator (PD1) die Phasenablage zwischen dem zyklisch auftretenden Überlaufimpuls (TS1) eines Schreibtakt-Zählers, welcher starr vom individuellen Datensignaltakt abhängt, und dem Überlaufimpuls (TL) eines Lesetakt-Zählers, welcher starr vom gemeinsamen Verarbeitungstakt abhängt, ermittelt,
- und daß das abgeleitete Regelkriterium (PSM) den Lesetakt (TL) des elastischen Speichers (ES1) regelt.

7. Anordnung nach Anspruch 6, dadurch gekennzeichnet, daß ein mit dem Regelkriterium (PSM) beaufschlagter spannungsgesteuerter Oszillator (VCO) den Lesetakt (TL) erzeugt.
